# EUROPEAN PATENT APPLICATION

(11) **EP 1 863 072 A1**
(43) Date of publication of application: **05.12.2007**
(21) Application number: 06447072.7
(22) Date of filing: 29.05.2006
(51) Int. Cl.: H01L 21/28, H01L 29/49, H01L 29/51

(54) **Method for modulating the effective work function**

(71) Applicant: INTERUNIVERSITAIR MICROELEKTRONICA CENTRUM ( IMEC), 3001 Leuven (BE); NATIONAL UNIVERSITY OF SINGAPORE, 117546 Singapore (SG)
(72) Inventor: Pantisano, Luigi, 3001 Leuven (BE); Schram, Tom, 1330 Rixensart (BE); De Gendt, Stefan, 2110 Wijnegem (BE)
(74) Representative: pronovem

(57) **Abstract**

A new MOSFET device is described comprising a metal gate electrode, a gate dielectric and an interfacial layer.

A method for its manufacture is also provided and its applications.

## Description

### Field of the invention

The present invention relates to semiconductor process technology and devices. In particular, the present invention relates to a method for modulating the effective work function of a gate electrode in a MOSFET device and the MOSFET device obtained by said method.

### Background

In the quest for CMOS scaling, alternative gate dielectrics exhibiting reduced leakage compared to the conventional SiO₂-based materials are required. High-k gate dielectric films are being considered and in particular Hf-based gate dielectrics materials.

However, severe limitations remain in the integration of conventional poly-Si gate electrodes with a high-k dielectric such as HfO₂. Indeed, despite improved leakage currents when using thin HfO₂ films, problems are still observed, such as low yield and poor threshold voltage control.

In case of polysilicon on SiO₂, the threshold voltage (Vₜ) of transistors can be tuned by doping the polycrystalline silicon (i.e., N or P type dopants). The doping of the poly-Si modifies the Fermi-level (FL) of the polysilicon thus achieving the desired Vₜ for nMOS or pMOS.

With the introduction of metal gates (in particular to avoid poly depletion effects), tuning by doping is no longer possible (since the FL of a metal gate electrode is set by the intrinsic workfunction of the metal or metallic compound used).

Different solutions have been proposed to solve this problem of Vₜ control.

A first approach relates to the use of fully-silicided gates (FUSI gates) with the eventual addition of dopants that pile up at the interface. Partly because of diffusion of the siliciding species through the dielectric, this process is known to generate further problems with high-k dielectrics, such as HfO₂ dielectric. Moreover it is difficult to control the silicidation process up to the interface between the gate electrode and the gate dielectric.

In a second approach, the gate electrode composition and deposition chemistry is changed to achieve the desired work function and thus the desired Vₜ. But very few candidates can meet the requirements in terms of stability, compatibility, etc., having regard to the different thermal and chemical treatments applied.

In a third approach the whole dielectric material is changed to achieve the desired band alignment. Similarly, very few candidates can meet the requirements in terms of performance, mobility, leakage, reliability, etc.

Hence, there is a need for a method for manufacturing MOSFET devices in which the effective work function and the threshold voltage of the metal gate electrode of each transistor type can be controlled in an easy, reproducible and efficient way.

### Summary

The present invention is based on the surprising discovery that the electrostatic potential at the interface between the gate electrode and the gate dielectric of a MOSFET device can be controlled by introducing one or more interfacial layer(s) of a dielectric material, at the monolayer (s) level (i.e. preferably two monolayers), between the gate electrode and the gate dielectric.

The present invention relates to a MOSFET device comprising, between a semiconductor substrate and a metal gate electrode:
- a gate dielectric comprising (or consisting of) at least one layer of a dielectric material having (or for meeting) (pre-)determined mobility, leakage and/or EOT specifications and,
- at the interface between said at least one dielectric layer and said metal gate electrode, an interfacial layer comprising or consisting of a lanthanum hafnium oxide material for modulating the effective work function of said metal gate,
wherein said at least one layer of a dielectric material (2) in contact with said interfacial layer is different from said interfacial layer material.

Preferably, said interfacial layer consists of less than about 10 monolayers, preferably of less than 5 monolayers, more preferably of one, two or three monolayer(s).

Preferably, said interfacial layer comprises (or consists of) La₂Hf₂O₇.

Said at least one layer of dielectric material can comprise (or consist of) any suitable high-k (i.e. k > 3,9) material, preferably comprises (or consists of) hafnium-oxide, more particularly comprises (or consists of) HfO₂.

Said metal gate electrode can comprise (or consist of) W, Ta, Pt and/or Mo, preferably TiN, TaN and/or Ru.

A MOSFET device according to the invention can further comprise a capping layer, such as TiN.

A method for the manufacture of such a MOSFET device is provided.

More particularly, a method of forming a gate in a MOSFET, FinFET or memory device, is provided, comprising the steps of:
- depositing, on a semiconductor substrate, at least one layer of a dielectric material for meeting ((pre-)determined) mobility, leakage and/or EOT specifications, and
- before forming the gate electrode, depositing at the interface between said at least one dielectric layer and the gate electrode, an interfacial layer comprising or consisting of a lanthanum hafnium oxide material, preferably consisting of La₂Hf₂O₇,
wherein said at least one layer of a dielectric material in contact with said interfacial layer is different from said interfacial layer material.

Preferably, said interfacial layer is deposited by means of Molecular Beam Epitaxy (MBE), preferably by means of UltraHigh Vacuum MBE (UHV MBE).

A method according to the invention can further comprise an annealing activation step (which can consists of applying a temperature comprised between about 700°C and about 1100°C, during a period of time varying between about 1 ms to about 20 min).

A method according to the invention can further comprise an FGA step.

Preferably, said gate electrode forming step comprises depositing in-situ a gate electrode layer, more particularly by sputtering.

A method according to the invention can further comprise a capping step whereby a capping layer is formed upon said gate electrode.

A method according to the invention can be used in paarticular for modulating the effective work function of said metal gate electrode

### Brief description of the drawings

Exemplary embodiments are illustrated in referenced figures of the drawings. It is intended that the embodiments and figures disclosed herein be considered illustrative rather than restrictive. Same numerals are used to refer to corresponding features in the drawings.

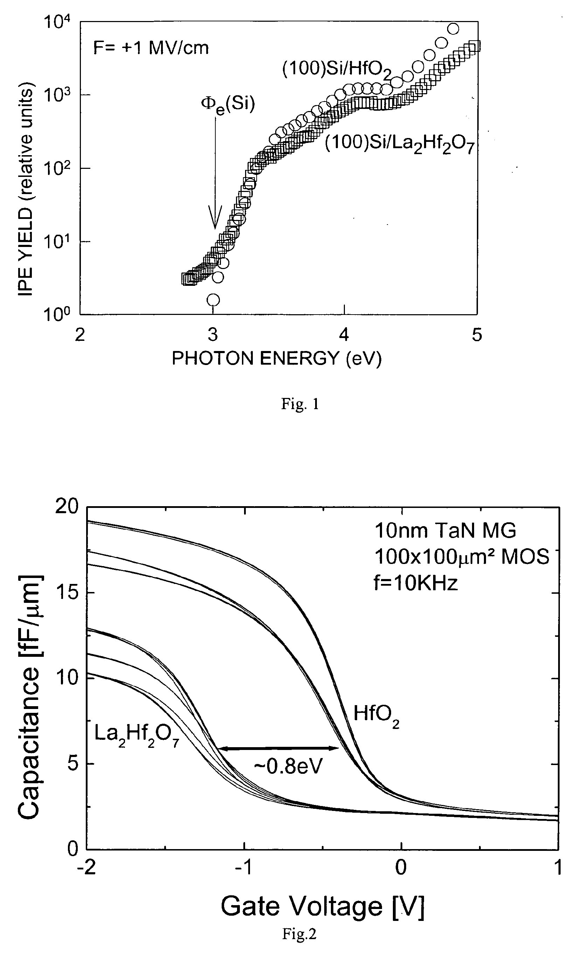

Figure 1. Quantum yield of electron internal photoemission (IPE) from the valence band of (100)Si into the conduction band of HfO₂ (O) and La₂Hf₂O₇ (□) insulators as a function of photon energy. The spectra are taken at the same strength of electric field in the insulator of 1 MV/cm with the gate electrode biased positively. The arrow indicates the spectral threshold using IPE.

Figure 2. C-V characteristics for MBE La₂Hf₂O₇ and MBE HfO₂ with the same TaN MG. The C-V measurements were done on large area overlapping capacitors. The physical thickness was respectively 3, 4 and 5nm for the HfO₂ samples and 4, 5 and 6nm for the La₂Hf₂O₇ ones. All samples have received a 1000°C, 1s anneal treatment.

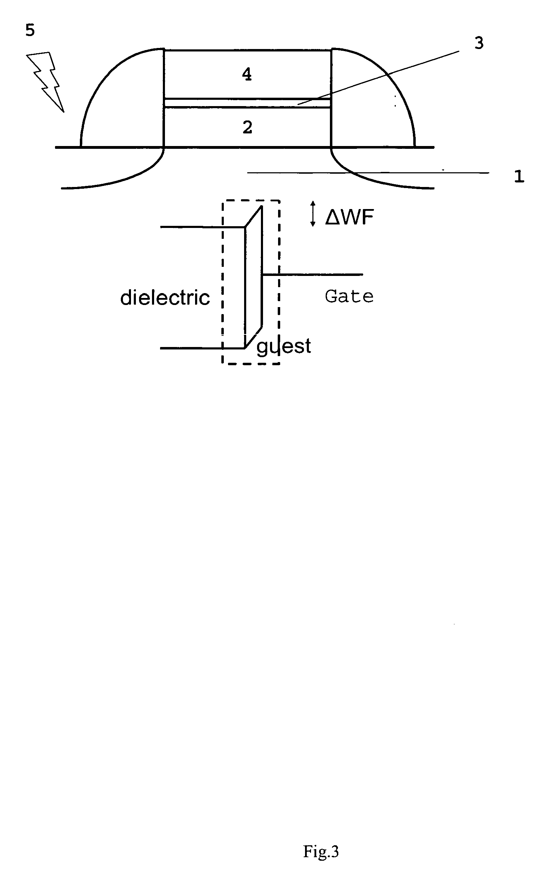

Figure 3(a) represents a schematic MOSFET with high-k, featuring a gate dielectric in contact with the Si-substrate and a guest layer to tune the effective WF. And in figure 3(b), the guest (dielectric) layer modifies the electrostatic potential at the interface. In this configuration the effective WF is reduced.

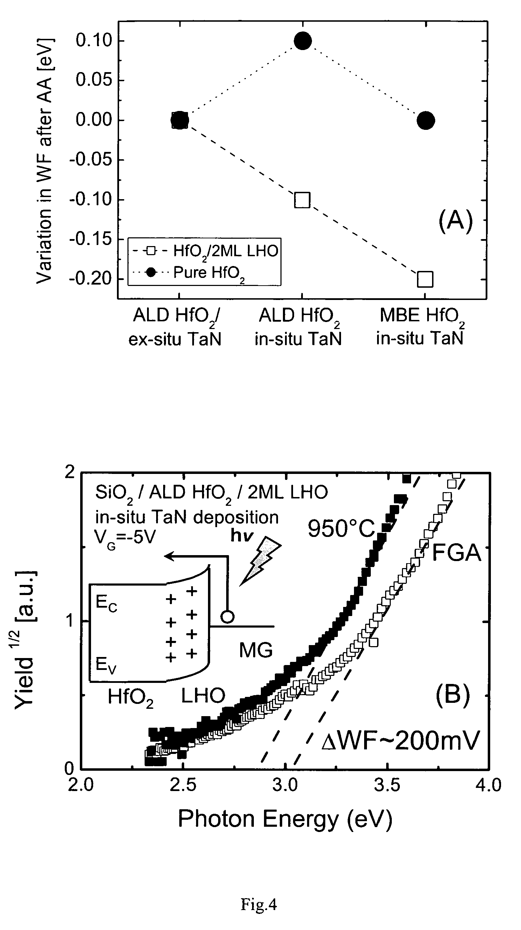

Figure 4(a) represents the change in the effective WF for HfO₂ (as the gate dielectric) and La₂Hf₂O₇ (also referred to LHO, as the guest layer) after activation in N₂ at 950°C for 30s. Before activation the effective WF was ~4.65eV. When 2MLs LHO and TaN are both deposited in situ, a WF reduction of -200meV is observed. The eWF was extracted using slant-etched wafers. Figure 4(b) represents the Fowler plot of the (internal photocurrent yield) ^{½} vs. photon energy for the samples of fig.4a. The barrier is perturbed by the 2MLs LHO after activation. In the inset a band diagram of the IPE experiment and band alignment is demonstrated.

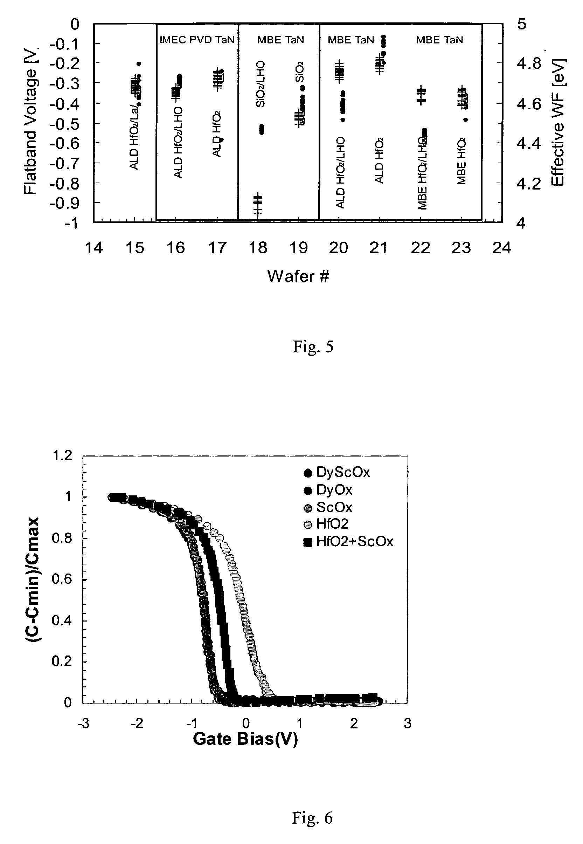

Figure 5 represents the FB and the extracted WF for the different stacks considered after and before 950°C anneal (dots after anneal, lines before anneal). Before anneal the WF is approximately 4.6 eV for most cases. After anneal, a WF decrease is observed for LHO capped layers with MBE (in situ TaN). No shift is observed for the HfO₂ with in situ TaN (in absence of LHO interfacial layer).

Figure 6 represents CV curves of PVD TiN gates on HfO₂ (gate dielectric) and ScOₓ (guest) capped HfO₂ after a 520°C forming gas anneal. A negative V_{FB} shift of approximately 0.4 V is observed, reflecting an effective WF change of approximately 0.4 eV. The effective WF of PVD TiN on bulk DyScOₓ (dysprosium scandate) , DyOₓ and ScOₓ are added and illustrate the potential of these materials to tune the effective WF to lower values.

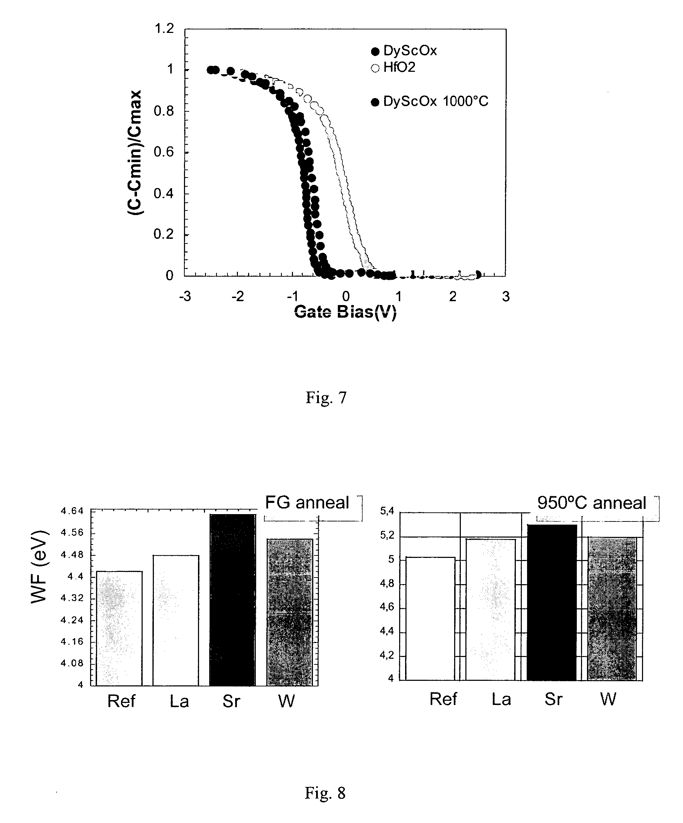

Figure 7 represents CV curves of PVD TiN gates on bulk DyScOₓ, before and after 1000°C anneal; and for comparison the CV of the same gate on HfO₂. It can be observed that the lower effective WF of DyScOₓ compared to HfO₂ is conserved after 1000°C anneal.

Figure 8 represents effective WF of ALD TiN gates on bulk SiO₂ and spin contamination based oxide deposition with a metal dose of approximately 5e13 atoms/cm², both before (left) and after 950°C anneal (right). An effective increase of the WF can be observed ranging from 0.08 to 0.22 eV, depending on the capping oxide (interfacial layer) used. The shift in effective WF relative to the WF on bulk SiO₂ is conserved after anneal. Using Sr in combination with a 950° C anneal and an ALD TiN gate, a nearly ideal WF for P-poly replacement of 5.3 eV is obtained.

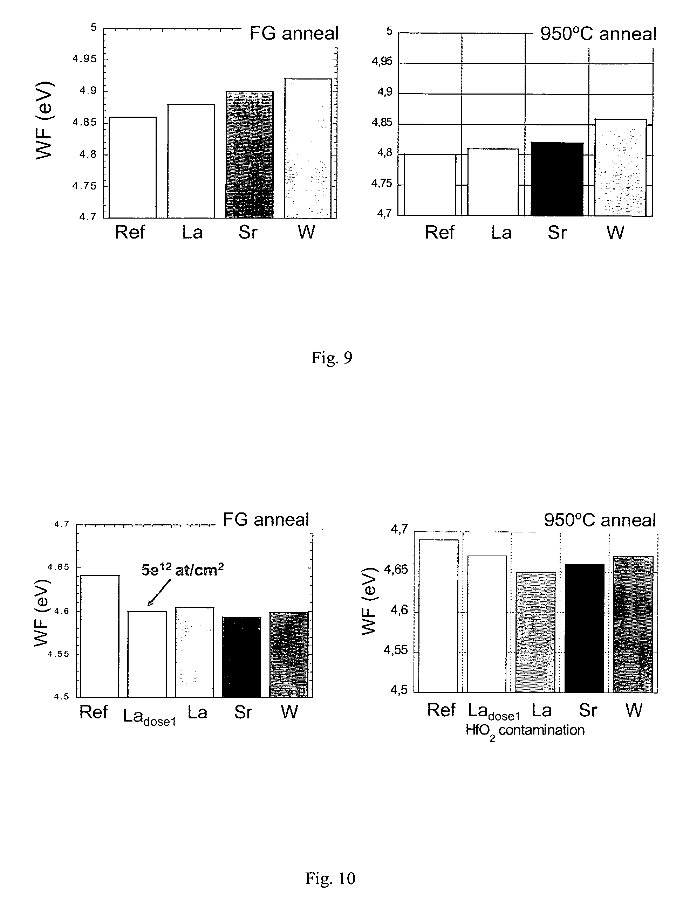

Figure 9 represents effective WF of ALD TiN gates on bulk HfO₂ and spin contamination based oxide deposition with a metal dose of approximately 5e13 atoms/cm², both before (left) and after 950°C anneal (right). An effective increase of the WF can be observed ranging from 0.02 to 0.06 eV, depending on the capping oxide (interfacial layer) used. The shift in effective WF relative to the WF on bulk HfO₂ is conserved after anneal.

Figure 10 represents effective WF of PVD TaN gates on bulk HfO₂ and spin contamination based oxide deposition with a metal dose of approximately 5e13 atoms/cm² (except where mentioned otherwise: dose1), both before (left) and after 950°C anneal (right). An effective decrease of the WF can be observed ranging from 0.04 to 0.05 eV, depending on the capping oxide (interfacial layer) used. The decrease in effective WF relative to the WF on bulk HfO₂ is conserved after anneal.

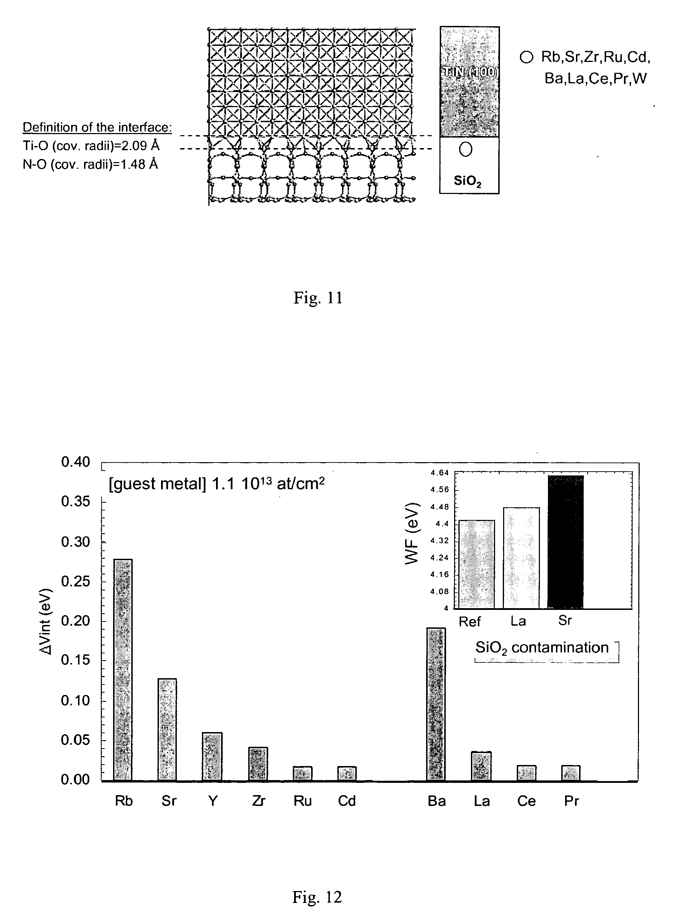

Figure 11 represents (left) an illustration of the atomic model used to calculate the interface electrostatic potential for the SiO₂/TiN case (without guest cap layer); (right) the location of the guest dielectric metal atoms in the model in case capping layers are modeled.

Figure 12 represents the calculated magnitude (estimate due to the limited model) of the difference in the interface electrostatic potential due to the introduction of the different oxide layers in the SiO₂/TiN interface. It is to be noted that the shift in electrostatic potential has to be inversed to estimate the effective WF shift. The inset that repeats the experimental data confirms the calculated relative magnitude of the induced effective WF shift for LaOₓ and SrOₓ.

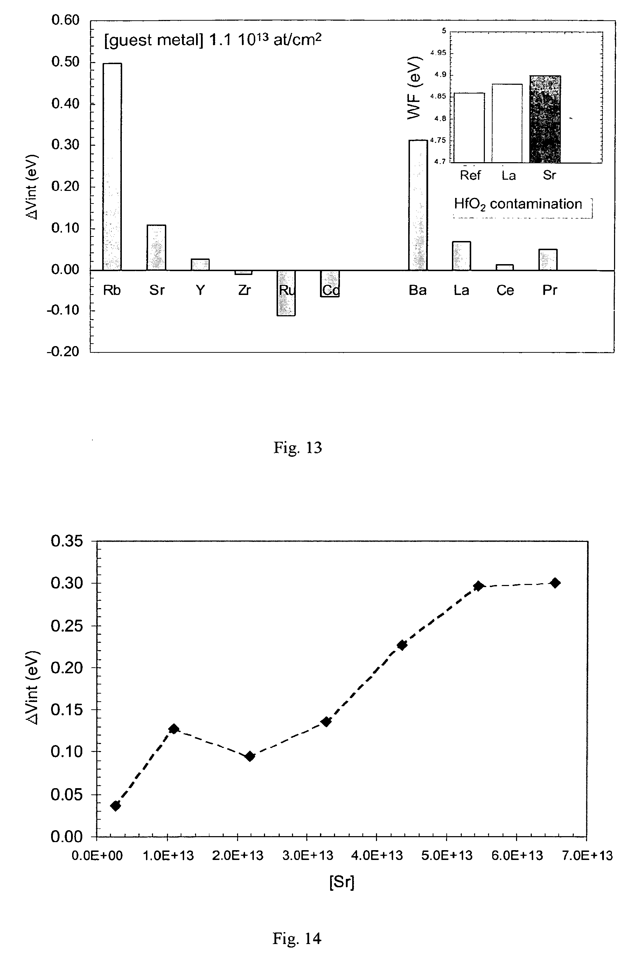

Figure 13 represents the calculated magnitude (estimate due to the limited model) of the difference in the interface electrostatic potential due to the introduction of the different oxide layers in the HfO₂/TiN interface. It is to be noted that the shift in electrostatic potential has to be inversed to estimate the effective WF shift. The inset that repeats the experimental data confirms the calculated relative magnitude of the induced effective WF shift for LaOₓ and SrOₓ.

Figure 14 represents the calculated magnitude (estimate due to the limited model) of the difference in the interface electrostatic potential due to the introduction of different amounts of SrOₓ guest (dielectric) layer (at the SiO_{2/}TiN interface). It is to be noted that the shift in electrostatic potential is dependent on the amount of guest dielectric present.

### Detailed description

In a MOSFET device, the interface between the gate dielectric and the gate critically determines the effective work function and thus, the MOSFET Vₜ .

A new MOSFET device is provided, comprising, between a semiconductor substrate and a gate electrode, a gate dielectric comprising (or consisting of) at least one layer of a dielectric material having (or for meeting) ((pre-)determined) mobility, leakage and/or EOT specifications and, at the interface between said gate dielectric and said gate electrode, an interfacial layer of a dielectric material, different from the dielectric material of the gate dielectric it contacts, for modulating the effective work function of said metal gate.

By providing a chemical bond polarization layer (also referred to herein as "guest layer", or "interfacial layer", or as "interlayer", or as "interface polarization layer", or as "dipole polarization layer") at a monolayer (ML) level (i.e. one monolayer to about 10 monolayers, preferably one to about five monolayers, more preferably about 2 monolayers), the effective work function of the metal gate electrode can be modulated.

More particularly, by depositing an ultra-thin interfacial layer of dielectric material, e.g. by ALD deposition, or preferably in a ultrahigh vacuum (UHV) Molecular Beam Epitaxy (MBE) chamber, the electrostatics potential at the interface (between the gate dielectric and the gate electrode) is modified, offering means to control the work function.

In the context of the present invention, the term "monolayer", is meant to encompass the term "sub-monolayer", and refers to a layer one molecule thick, without necessarily implying, a uniform and/or total coverage of the surface concerned.

Preferably, the term "monolayer" is meant to refer to a layer of sufficient amount of material to achieve full surface coverage, i.e. to achieve full closure of the film, such that no atom of the surface to be covered is exposed (left uncovered).

Said interfacial layer can comprise or consist of any suitable material used as dielectric material in MOSFET devices and is different from the gate dielectric material forming the interface (i.e. it contacts). In particular, said material can comprise or consist of SiO₂, SiON, HfO₂, HfSiO, HfZrO, HfZrSiO, HfZrSiON, HfSiON, Al₂O₃, HfAlOₓ, and possibly other Hf and Zr based dielectrics.

Preferably, said interfacial layer comprises or consists of any of Ca, Li, Mg, Lu Nd, Fr, Ra (Na,K) based oxides, or Al₂O₃, or preferably any of Cs, or Rb, Ba, Sr, La, Y, Zr, Ru, W based oxides.

More preferably, said interfacial layer comprises or consists of LaHfOₓ (lanthanum hafnium oxide), DyOₓ, ScOₓ, or DyScOₓ (dysprosium scandate).

More preferably, said interfacial layer comprises or consists of La₂Hf₂O₇.

Preferably, said interfacial layer consists of less than about 10 monolayers, preferably of less than 5 monolayers, more preferably consists of one, two or three monolayers.

Preferably, said interfacial layer of dielectric material is submitted to a high temperature treatment, more particularly to a temperature higher than 700°C or 800°C, preferably higher than 900°C, more preferably comprised between about 700°C and about 1100°C. Said high temperature treatment can be applied during a period which can vary from few milliseconds to few minutes, preferably from (about) 1s to (about) 20 min.

In particular, said interfacial layer can comprise a metal element, the electro-negativity of which has to be sufficiently different from that of the metal element (if any) of the gate dielectric.

Additionally it is preferred that the electro-negativity of the metal element of the guest dielectric (interfacial layer) is also sufficiently different from that of the metal element of the metal gate.

More particularly, the electro-negativity difference between the metal in the guest dielectric and the metal in one of the surrounding materials (host dielectric or metallic gate) is larger than 0.05 Pauling units, preferably larger than 0.1 Pauling units, more preferably larger than 0.4 Pauling units.

For some materials, in particular those reacting with the adjacent layers, said interfacial layer may not be defined in terms of thickness.

Said gate dielectric can comprise or consist of at least one layer of a dielectric material. Preferably, said gate dielectric consists of one layer of a dielectric material.

Said dielectric material can comprise or consist of SiO₂, SiON, HfO₂ HfSiO, HfZrO, HfZrSiO, HfZrSiON, HfSiON, Al₂O₃, HfAlOₓ, and possibly other Hf and Zr based dielectrics.

More particularly, said dielectric material comprises (or consists of) any suitable high-k (i.e. k > 3,9) material.

Preferably, said gate dielectric material comprises or consists of HfO₂ or SiO₂.

Preferably, said gate electrode is a metal gate electrode (e.g. any metal gate electrode suitable for MOSFET devices). More particularly, said metal gate electrode can comprise or consist of W, Ta, Pt or Mo. More preferably, said metal gate electrode comprises or consists of TiN, TaN or Ru.

The present invention also relates to a new method for the manufacture of a MOSFET device according to the invention.

In particular, a method of the invention can be used for modulating the effective work function of a gate electrode in a MOSFET device.

More particularly, a method of the invention comprises the steps of:
- depositing, on a semiconductor substrate, at least one layer of a dielectric material for meeting ((pre-)determined) mobility, leakage and/or EOT specifications, and
- before forming the gate electrode, depositing, at the interface between said at least one dielectric layer and said gate electrode, an interfacial layer of a dielectric material.

In a method according to the invention, the material used for said interfacial layer is different from said gate dielectric material it contacts.

Preferably, said interfacial layer consists of less than about 10 monolayers, preferably of less than 5 monolayers, more preferably of one, two or three monolayers.

Depending on the material used, said interfacial layer can be deposited by means of Chemical Vapor Deposition (CVD), by Atomic Layer Deposition (ALD), or preferably by means of Molecular Beam Epitaxy (MBE), and more preferably by means of UltraHigh Vacuum Molecular Beam Epitaxy (UHV MBE).

More particularly, when said interfacial layer consists of DyOₓ , ScOₓ , DyScOₓ, CVD or ALD can be used. When said interfacial layer consists of LaOₓ, WOₓ, or SrOₓ, the deposition can be performed by spinning followed by oxidation.

A method according to the invention can further comprise an annealing activation step (also referred to as a high temperature treatment). Preferably the temperature is higher than about 700°C, or 800°C or 900°C and more particularly comprised between about 700°C and about 1100°C. The high temperature treatment can be applied during a period of time varying between few milliseconds to few minutes, e.g. 1ms to 20 min.

Preferably, a method according to the invention further comprises a Forming Gas Anneal (FGA) step.

In a method according to the invention, said gate electrode forming step preferably comprises (or consists of) depositing in-situ a gate electrode layer, more particularly by sputtering.

A method according to the invention can further comprise a capping step, whereby a capping layer is formed upon said gate electrode, such as a TiN capping layer.

In a method according to the invention, said gate electrode comprises (or consists of) a metal gate electrode.

The materials that can be use in a method according to the invention are those defined for a MOSFET of the invention.

Preferably, the gate material is deposited in-situ, after depositing said interfacial layer.

According to a preferred embodiment, the gate electrode is a metal gate electrode, preferably consisting of TaN, the gate dielectric consists of HfO₂, and the interfacial layer consists of 2 monolayers of La₂Hf₂O₇.

Accordingly in a preferred method of the invention, the gate electrode is a metal gate electrode, preferably consisting of TaN, the gate dielectric consists of HfO₂, and the interfacial layer consists of 2 monolayers of La₂Hf₂O₇.

A method of the invention can also be used for the manufacture of further devices such as FinFET devices or memory devices. Accordingly, FinFET and/or memory devices are also objects of the present invention.

### Examples

### Example 1.

High-k dielectrics featuring Hf0₂ or La₂Hf₂O₇ (LHO) were considered. These dielectrics were deposited either by atomic layer deposition (using HfCl₄ and H₂O as chemical precursors) or by Molecular Beam Epitaxy on .200mm-Si wafers.

The 10 nm thick TaN metal gate (also referred to as MG) was deposited by sputtering, in- or ex situ, and capped with 70nm TiN.

Overlapping MOS Capacitors were processed in a conventional flow.

MOSFETs were processed using an etched gate and encapsulating spacer.

Several temperatures of activation anneal (high temperature treatment) were evaluated, followed by FGA (Forming Gas Anneal(ing)).

In some experiments, the effective WF was extracted using C-V measurements. This was done on capacitors where the high-k was deposited on a thick SiO₂ whose thickness is varied by chemical etching (slant etch).

Further measurement of the potential barrier between the gate electrode and the dielectric has been done using the internal photoemission (IPE).

In the IPE experiment, an ultraviolet light source is used to excite electrons in the MG (see inset of fig. 1). As soon as the photon energy is close enough to the barrier height of the MG / dielectric interface, a photocurrent can be measured. For a given applied field the barrier height can be inferred from the plot of photocurrent yield vs. the photon energy.

For HfO₂ and LHO grown on (100) Si substrates, the IPE reveals the same energy barrier between the top of the Si valence band and the bottom of the oxide conduction band. This is illustrated by the IPE spectra shown in fig.1 for HfO₂ and LHO measured under the same electric field strength in the oxide. The extracted barrier height of 3eV at 1MV/cm (see fig. 1) is the same for both insulating layers. This is consistent with the general idea that the conduction band is derived from the same unoccupied 5d-states of the metal cations in the oxide.

In contrast to the Si/dielectric interface, the composition of the dielectric has a significant influence in the band alignment of the dielectric / MG interface. For the same integration scheme and TaN MG considered, the effective WF is 3.9eV and 4.5eV for respectively MBE LHO and MBE HfO₂ (see fig.2). Consistent with the idea that the effect observed is related only to the MG/ interface, in Fig.2 the V_{fb} seems to be independent of the dielectric thickness (i.e., negligible fixed charge Qox).

Since all the interactions responsible for eWF changes are limited to the interfacial layer between the MG and the dielectric, the eWF can be tuned by monolayer (ML) controlled deposition of a guest dielectric (interfacial layer) on top of a well known gate dielectric.

This concept is illustrated in fig.3 which shows the MOSFET gate insulator comprising of the gate dielectric part and the guest over layer deposited to tune the MG eWF. The gate dielectric (in this example Hf0₂) can be engineered to reach the mobility, leakage and EOT specifications. The guest dielectric (interfacial layer) and the MG can be engineered for optimal (dual) WF (and MG etchability).

Feasibility of eWF tunability is demonstrated in fig.4a, by deposition of 2MLs of LHO on top of a HfO₂ layer (gate dielectric).

The deposition is done in a UHV-MBE chamber for better control.

Without activation anneal, the WF of TaN is unperturbed by the LHO deposition. The effective WF in this condition is 4.65eV.

However, after activation the WF with the 2MLs guest LHO is reduced by ~200mV, as shown in fig.4a.

Fig. 4a also suggests that the WF reduction is larger when the MG is deposited in situ on the dielectric.

Direct measurement of the energy barrier between the TaN Fermi Level and the oxide conduction band using IPE electrons proves the finding regarding the barrier lowering by the LHO interlayer. As shown in the Fowler plot of the IPE yield of fig.4b, an incorporation of LHO followed by high temperature anneal leads to the shift of the spectral curve to lower photon energy as compared to the reference case (after FGA - 520°C). This effect is not observed for pure HfO₂ (not shown). Apparently the annealing of (positive) polarization layer effectively reduces the barrier height and the corresponding eWF (see inset of fig.4b).

### Example 2.

Referring to figures 8 to 10, a La, Sr or W based oxide was deposited on SiO₂ and HfO₂ respectively by spin contamination form nitride based standard solutions.

The depositions were tuned to deposit a metal dose of approximately 5e12 and 5e13 atoms/cm² for each of the used species. Assuming only the metal would be present; a dose of 5e12 and 5e13 atoms/cm² would correspond to a sub-monolayer and approximately a monolayer coverage. However, due to the fact that the considered species oxidize easily in air, and the volume of their oxides is bigger than that of the pure metals, the monolayer coverage is most likely reached with the 5e13 atoms/cm² dose.

Natural oxidation of the considered species occurs (or at least is expected to occur) after deposition of the metal species.

The interfacial layers were combined with both ALD TiN and PVD TaN gates.

Effective WF extractions were based on the CV based method (V_{FB} vs. EOT extrapolation) using a slant etched Si0₂ (allowing the EOT variation in one wafer); that was or was not capped with Hf0₂ depending on the case considered. Effective WF extractions were both done after [520°C FGA during 20 min] and [950°C, 30 s N₂ anneal + 520°C FGA during 20 min].

In order to confirm the cause of this effective WF shift the interface electrostatic potential between the high-k dielectric and the metal gate was calculated based on an atomic interface model, calculating the charge distribution in the interface region using the electronegativities of the involved elements.

To model the guest capping oxide some of the metal elements of the host oxide (Si or Hf) are replaced by those of the guest oxide (Rb, Sr, Zr, Ru, Cd, Ba, La, Ce, Pr, W) in the upper atomic layers of the host oxide, as such forming an effective layer or sub-monolayer of the guest oxide.

These calculations indicate that an effective WF change can be obtained by changing both the guest dielectric as well as the amount of guest dielectric at the sub-monolayer to monolayer level (see figures 11 to 14).

## Claims

1. A MOSFET device comprising, between a semiconductor substrate (1) and a metal gate electrode (4):
- a gate dielectric (2) comprising (or consisting of) at least one layer of a dielectric material having (or for meeting) (pre-)determined mobility, leakage and/or EOT specifications and,
- at the interface between said at least one dielectric layer (2) and said metal gate electrode (4), an interfacial layer comprising or consisting of a lanthanum hafnium oxide material (3) for modulating the effective work function of said metal gate
wherein said at least one layer of a dielectric material (2) in contact with said interfacial layer is different from said interfacial layer material.

2. A MOSFET device according to claim 1, wherein said interfacial layer (3) consists of less than about 10 monolayers, preferably of less than 5 monolayers, more preferably of one, two or three monolayer(s).

3. A MOSFET device according to claim 1 or 2, wherein said interfacial layer comprises (or consists of) La₂Hf₂O₇.

4. A MOSFET device according to any of claims 1 to 3,
wherein said at least one layer of dielectric material comprises (or consists of) any suitable high-k (i.e. k > 3,9) material.

5. A MOSFET device according to claim 4, wherein said high-k material comprises (or consists of) hafnium-oxide, more particularly comprises (or consists of) HfO₂.

6. A MOSFET device according to any of claims 1 to 5,
wherein said metal gate electrode comprises (or consists of) W, Ta, Pt and/or Mo, preferably TiN, TaN and/or Ru.

7. A MOSFET device according to any of claims 1 to 6, further comprising a capping layer comprising (or consisting of) TiN.

8. A method of forming a gate ((2), (3), (4)), in a MOSFET (5), FinFET or memory device, comprising the steps of:
- depositing, on a semiconductor substrate (1), at least one layer of a dielectric material (2) for meeting ((pre-)determined) mobility, leakage and/or EOT specifications, and
- before forming the gate electrode (4), depositing at the interface between said at least one dielectric layer (2) and the gate electrode (4), an interfacial layer comprising or consisting of a lanthanum hafnium oxide material (3), preferably consisting of La₂Hf₂O₇,
wherein said at least one layer of a dielectric material (2) in contact with said interfacial layer is different from said interfacial layer material.

9. A method according to claim 8, wherein said interfacial layer is deposited by means of Molecular Beam Epitaxy (MBE), preferably by means of UltraHigh Vacuum MBE (UHV MBE).

10. A method according to claim 8 or 9, further comprising an annealing activation step.

11. A method according to any of claims 8 to 10, further comprising an FGA step.

12. A method according to any of claims 8 to 11, wherein said gate electrode forming step comprises depositing in-situ a gate electrode layer.

13. A method according to claim 12, wherein said in-situ deposition is performed by sputtering.

14. A method according to any of claims 8 to 13, further comprising a capping step whereby a capping layer is formed upon said gate electrode.

15. A method according to any of claims 8 to 14, wherein said at least one layer of dielectric material comprises (or consists of) hafnium-oxide, more particularly comprises (or consists of) HfO₂.

16. A method according to any of claims 8 to 15, wherein said metal gate electrode comprises (or consists of) W, Ta, Pt and/or Mo, preferably TiN, TaN and/or Ru.

17. A method according to any of claims 14 to 16,
wherein said capping layer comprises (or consists of) TiN.

18. Use of a method according to any of claims 8 to 17 for modulating the effective work function of said metal gate electrode.

19. A MOSFET, FinFET or memory device obtainable by a method according to any of claims 8 to 17.
